Europäisches Patentamt

European Patent Office

Office européen des brevets

(19)

(11) Numéro de publication : **0 319 415 B1**

(12) **FASCICULE DE BREVET EUROPEEN**

(45) Date de publication du fascicule du brevet :
**20.05.92 Bulletin 92/21**

(51) Int. Cl.$^5$ : **H03L 7/10, H03C 3/09**

(21) Numéro de dépôt : **88403027.1**

(22) Date de dépôt : **01.12.88**

(54) **Dispositif d'asservissement rapide et à faible bruit de la fréquence et de la phase d'un signal à un signal imposé.**

(30) Priorité : **03.12.87 FR 8716947**

(43) Date de publication de la demande :
**07.06.89 Bulletin 89/23**

(45) Mention de la délivrance du brevet :
**20.05.92 Bulletin 92/21**

(84) Etats contractants désignés :
**DE GB IT NL**

(56) Documents cités :
**EP-A- 0 092 657**
**FR-A- 2 535 545**
**US-A- 4 433 308**
**US-A- 4 748 425**

(56) Documents cités :
**PATENT ABSTRACTS OF JAPAN, vol. 10, no.
113 (E-399)[2170], 26 avril 1986, page 137 E
399; & JP-A-60 249 429 (FUJITSUK.K.) 10-
12-1985**
**IDEM**
**IBM TECHNICAL DISCLOSURE BULLETIN,
vol. 21, no. 6, novembre 1978, pages
2482-2483, New York, US; D.R. IRVIN: "FM
anglemodulator with frequency compensated
deviation"**

(73) Titulaire : **INSTITUT FRANCAIS DU PETROLE
4, Avenue de Bois Préau
F-92502 Rueil-Malmaison (FR)**

(72) Inventeur : **Coquerel, Patrick
52, rue Hoche
F-78800 Houilles (FR)**

EP 0 319 415 B1

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

L'invention a pour objet un dispositif d'asservissement rapide et à faible bruit de la fréquence et la phase d'un signal à celle d'un signal imposé, d'un type connu sous le nom de boucle à verrouillage de phase ou PLL. Le dispositif trouve ses applications notamment pour la réalisation d'oscillateurs pilotes dans des émetteurs-radio à modulation de fréquence ou bien encore la récupération d'un signal d'horloge rythmant la transmission de données numérisées, on peut l'utiliser par exemple dans les systèmes de transmission de données sismiques.

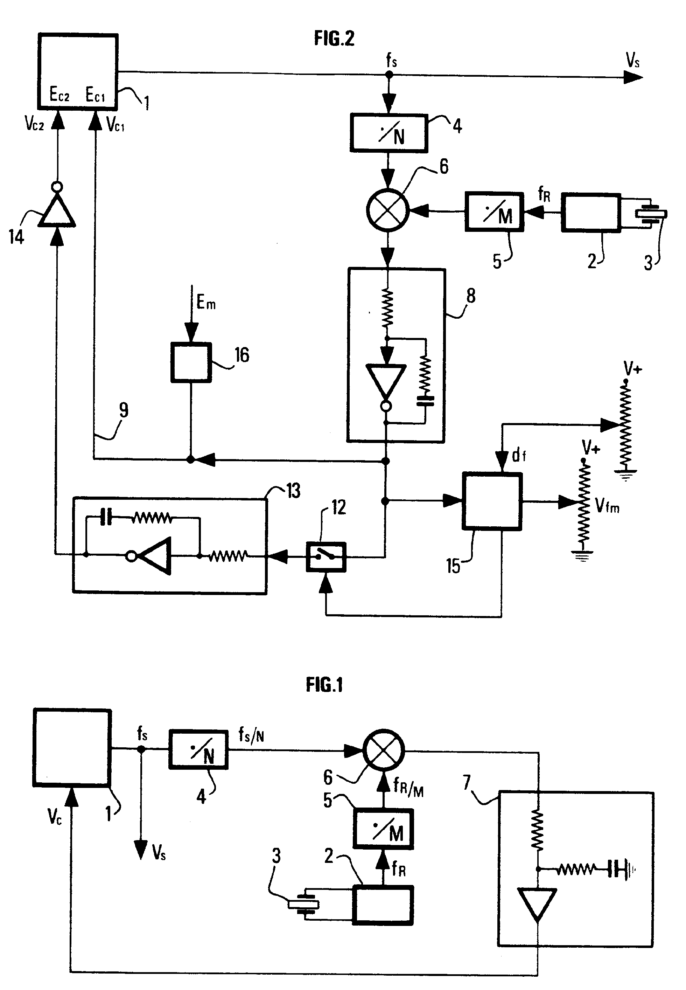

Comme on le verra plus en détail, en relation avec la figure 1, un circuit à verrouillage de phase classique comporte généralement un oscillateur à quartz dont la fréquence d'oscillation $f_R$ est utilisée comme référence.

Le signal issu de l'oscillateur est appliqué par exemple à un élément qui divise sa fréquence par un facteur M fixe ou ajustable. Le signal résultant est mélangé par un modulateur avec un autre signal dont la fréquence est un sous-multiple (dans un rapport N déterminé) de celle d'un signal issu d'un oscillateur à fréquence ajustable tel qu'un oscillateur commandé par tension (VCO). La tension électrique issu du modulateur, réduite à sa composante de basse fréquence par un filtre du premier ou du second ordre, est appliquée à l'entrée de commande de l'oscillateur (VCO). Une telle boucle a la propriété de verrouiller la fréquence du signal issu de l'oscillateur (VCO) à une fréquence $f_s$ proportionnelle à la fréquence $f_R$ de l'oscillateur de référence, le rapport de proportionalité étant égal à N/M. Le temps de calage ou verrouillage de la boucle varie, on le sait, proportionnellement à la constante de temps du filtre intégrateur et en raison inverse du gain de la boucle caractérisé notamment par un facteur $K_{vco}$. Ce facteur désigne le rapport entre la variation de fréquence de l'oscillateur commandé (VCO) et la tension de commande provoquant cette variation et s'exprime en kilohertz ou mégahertz par volt (kHz/V ou MHz/V).

Une telle boucle à verrouillage est également caractérisée par son "bruit" de phase, ce terme désignant les fluctuations de la phase du signal à la sortie de l'oscillateur commandé, après le calage de la boucle. Le bruit de phase mesuré est en général proportionnel au rapport entre la fréquence $f_s$ du signal issu de l'oscillateur commandé et celle du signal de référence et varie en raison inverse du temps de réponse du filtre disposé dans la boucle de contre-réaction (ou d'asservissement). La vitesse de verrouillage de la boucle dépendant directement de ce temps de réponse, on constate qu'il est difficile de concilier rapidité de verrouillage et faible bruit de phase.

Dans le brevet JP 60 249 429 est décrit un circuit à verrouillage de phase où la fréquence émise par un oscillateur du type VCO est ajustée par un circuit d'asservissement comportant deux filtres passe-bas dont les constantes de temps sont différentes l'une de l'autre. Un commutateur commandé par des moyens de sélection permet de connecter successivement le plus rapide puis le plus lent après une réinitialisation quand l'accord de fréquence est presque réalisé.

Par le brevet US No. 4 433 308, on connait un circuit de détection à verrouillage de phase adapté à s'accorder sur la fréquence d'un signal FM appliqué à son entrée comportant un oscillateur VCO et un filtre actif dont la constante de temps varie de façon discontinue selon la valeur de l'écart de fréquence entre la fréquence d'un signal FM appliqué et la fréquence de l'oscillateur, ce circuit étant agencé pour supprimer la tension d'offset apparaissant aux instants de commutation de la constante de temps du filtre.

Dans la demande de brevet EP 92 657, est décrit un circuit d'accord pour un récepteur HF, pourvu d'un filtre de boucle passe-bas dont les caractéristiques changent par une mise en parallèle automatique sur une résistance, d'une ou plusieurs résistances, au moyen d'un réseau de résistances et de diodes, de façon à faire varier par paliers successifs la constante de temps du filtre de boucle.

Le dispositif à verrouillage de phase selon l'invention permet de réaliser l'asservissement de la fréquence et de la phase d'un signal à celle d'un signal imposé issu d'un oscillateur de référence avec tout à la fois un temps de réponse très court et un bruit de phase maintenu à un niveau très bas.

Le dispositif selon l'invention comporte un oscillateur asservi dont la fréquence d'oscillation est commandée par application d'une tension sur une entrée de commande, une première boucle fermée de contre-réaction comprenant un premier filtre passe-bas pour produire une première tension de commande optimale propre à stabiliser la fréquence de l'oscillateur asservi, le bruit de phase inhérent à ladite première boucle et sa vitesse de réponse étant relativement faibles.

Il est caractérisé en ce qu'il comporte en parallèle sur ladite première boucle, une deuxième boucle d'asservissement comportant un deuxième filtre passe-bas dont l'entrée est reliée à la sortie du premier filtre passe-bas et dont la sortie est reliée à une deuxième entrée de commande de l'oscillateur asservi, une variation de la tension de commande appliquée à ladite deuxième entrée de commande provoquant un déplacement de la fréquence de sortie de l'oscillateur plus grand que celui produit par la même variation de cette tension de commande appliquée à ladite première entrée, la sortie du premier filtre passe-bas étant reliée à ladite première entrée de commande, et des moyens de contrôle pour fermer ladite deuxième boucle par intermittence tant que l'écart entre la tension de commande et ladite valeur optimale, est supérieur à une valeur-seuil déterminée, la deuxième boucle incluant des moyens de mémorisation de tension.

La première boucle d'asservissement étant fermée en permanence, on évite les dérives de fréquence et les phénomènes transitoires qui peuvent intervenir aux instants de commutation quand on fait intervenir successivement deux boucles différentes.

Les moyens de connexion de la première boucle comportent par exemple un moyen d'application d'un signal de modulation dont l'amplitude est choisie inférieure à la largeur de la fenêtre de tension du comparateur de tension. La structure du dispositif avec une seconde boucle rapide qui n'intervient que par intermittence, permet d'élargir vers les basses fréquences la bande de fréquence de modulation sans perturber la stabilité de fonctionnement, tant que l'amplitude du signal de modulation reste dans les limites fixées pour le comparateur de tension.

Les moyens de contrôle utilisés pour fermer la seconde boucle par intermittence, comportent par exemple des moyens de commutation commandés par un comparateur de tension qui est adapté à comparer la tension de commande avec une tension de référence.

D'autres caractéristiques et avantages du dispositif selon l'invention apparaîtront à la lecture de la description d'un mode de réalisation donné à titre d'exemple non limitatif et en se référant aux dessins annexés sur lesquels :

– la figure 1 montre schématiquement un dispositif d'asservissement de fréquence d'un type connu;

– la figure 2 montre un schéma synoptique du dispositif selon l'invention;

– la figure 3 représente schématiquement un exemple d'oscillateur asservi associé à des moyens capacitifs pour modifier sa fréquence d'oscillation;

– la figure 4 montre une courbe représentative de l'écart de fréquence d'oscillation de l'oscillateur asservi pour une certaine variation de la tension de commande appliquée à un moyen capacitif par l'intermédiaire de la seconde boucle; et

– la figure 5 montre une courbe analogue pour le moyen capacitif actionné par la première boucle.

Il est connu de réaliser un dispositif à verrouillage de phase ou de fréquence à boucle d'asservissement unique, tel que celui représenté à la figure 1. Ce dispositif connu comporte un oscillateur asservi 1 dont la fréquence $f_s$ est susceptible de varier par application d'une tension de commande, du type VCO par exemple et un oscillateur de référence 2 oscillant à une fréquence $f_R$ de référence fixée par un quartz 3. Les signaux issus des deux oscillateurs 1 et 2 sont appliqués respectivement à deux éléments diviseurs de fréquence 4, 5 appliquant des facteurs de division N pour le premier, M pour le second. Les signaux de fréquence $f_s/N$ et $F_R/M$ issus des deux éléments diviseurs 4, 5, sont appliqués à un modulateur 6. La composante de basse fréquence $V_c$ du signal résultant est isolée par un filtre pass-bas du premier ou du second ordre 7 et sert de tension de commande pour faire varier la fréquence $f_s$ du signal émis par l'oscillateur asservi 1. Après verrouillage de la boucle, cette fréquence $f_s$ est égale à $f_R.N/M$.

La vitesse de calage (ou verrouillage) de la boucle varie en raison inverse de la constante de temps du filtre et proportionnellement à un facteur $K_{vco}$ défini par la relation :

$$K_{VCO} = \frac{\Delta f_s}{\Delta V_c}$$

où $\Delta f_s$ désigne la variation de la fréquence de l'oscillateur asservi 1 lorsque la tension de commande varie d'un échelon déterminé $\Delta V_c$. Le bruit de phase au contraire varie proportionnellement à la même constante de temps et en raison inverse du facteur $K_{VCO}$ défini ci-dessus.

La diminution du bruit de phase d'une telle boucle ne peut donc être obtenue qu'au prix d'un ralentissement de la vitesse de verrouillage.

Sur le schéma de la figure 2 représentant un mode de réalisation de l'invention, les éléments identiques à ceux de la figure 1 portent les mêmes références numériques 1 à 6.

Le signal issu du modulateur 6 est appliqué à un intégrateur 8 dont la constante de temps d'intégration est choisie relativement grande. Le signal $V_{c1}$ issu de l'intégrateur est appliqué par une connexion 9 à une première entrée de commande $E_{c1}$ de l'oscillateur asservi 1.

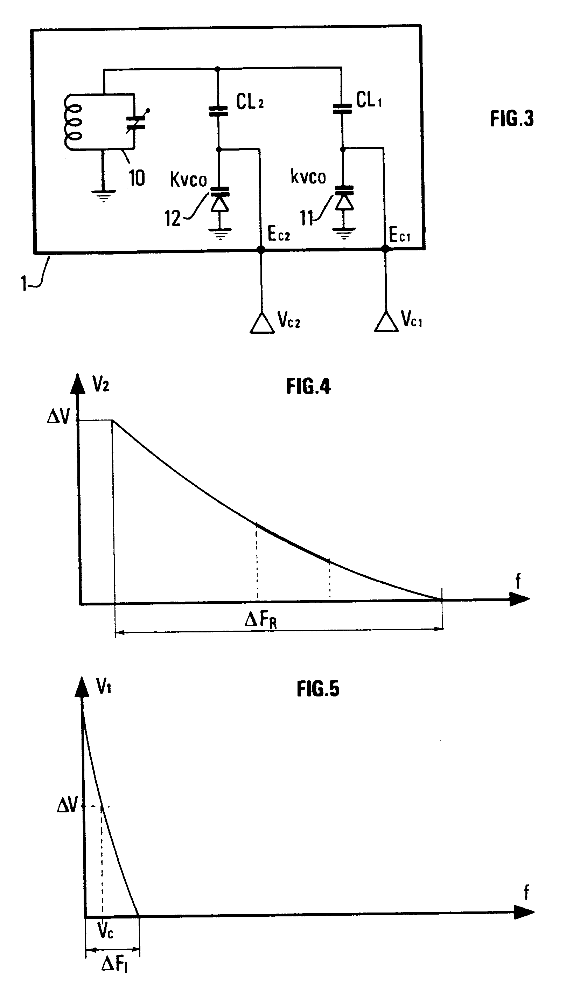

Celui-ci est d'un type connu et comporte par exemple (figure 3) un circuit oscillant 10 relié par un condensateur de liaison $C_{L1}$ à une première diode du type "varicap" 11. Une première entrée $E_{c1}$ permet d'appliquer à la diode 11 une tension de commande $V_{c1}$ qui modifie sa capacité propre. Un second condensateur de liaison $C_{L2}$ connecte au circuit oscillant 10 une seconde diode 12 du type varicap également, laquelle est commandée par application d'une seconde tension de commande $V_{c2}$ appliquée sur une entrée $E_{c2}$. Les diodes 11 et 12 et les condensateurs de liaison. $C_{L1}$ et $C_{L2}$, sont choisis de telle manière que le facteur $k_{vco}$ correspondant à l'entrée $E_{c1}$ soit beaucoup plus petit que le facteur $K_{vco}$ correspondant à l'autre entrée $E_{c2}$. Ceci est traduit par les courbes des figures 4 et 5 qui montrent que l'écart $\Delta F_R$ de la fréquence d'oscillation provoqué par un même échelon $\Delta V$ de la tension de commande appliquée sur l'entrée $E_{c2}$, est beaucoup plus grand que l'écart correspondant $\Delta F_L$ observé par action sur l'entrée $E_{c1}$.

La sortie de l'intégrateur 8 (figure 2) est connectée par l'intermédiaire d'un commutateur analogique 12, à un second intégrateur 13 dont la constante de temps d'intégration est beaucoup plus courte que celle du précédent (8). La sortie de l'intégration 13 est connectée par l'intermédiaire d'un amplificateur inverseur 14, à la seconde entrée $E_{c2}$ de l'oscillateur asservi 1.

Le commutateur 12 est actionné par un comparateur du type "à fenêtre" 15 auquel on applique une tension de référence stable $V_{fm}$. L'élément 15 compare à cette tension de référence, la tension de sortie de l'intégrateur 8. Tant que sa valeur est située en dehors d'un intervalle ou fenêtre de tension de largeur déterminée mais réglable $d_f$ centré sur la tension de référence $V_{fm}$, le comparateur 15 maintient fermé le commutateur 12. Dès que sa valeur franchit le seuil haut ou bas de part et d'autre de $V_{fm}$, il commande l'ouverture du commutateur 12, ce qui a pour effet de stabiliser la tension à la sortie de l'intégrateur 13. Celui-ci agit comme un moyen de mémorisation. Un élément 16 relié à la connexion 9, permet d'appliquer une tension de modulation extérieure $E_m$, de manière à moduler en fréquence le signal $V_s$ issu de l'oscillateur asservi 1, sans que cette modulation perturbe le verrouillage du fait de la constante de temps relativement importante de l'intégrateur 8 et de l'effet d'hystérésis propre au comparateur à fenêtre de la boucle "rapide" qui autorise une excursion ajustable df de la phase et de la fréquence du signal $f_s$.

On choisit une tension de référence $V_{fm}$ proche de la valeur de la tension de commande qui assure la stabilisation de l'oscillateur asservi ce qui permet à la boucle lente de fonctionner toujours sur une plage très linéaire de la caractéristique capacité/tension de la diode varicap 11 (entrée $E_{c1}$). Pour obtenir une certaine modulation du signal synthétisé, il n'est plus nécessaire d'adapter à la fréquence de celui-ci, l'amplitude du signal modulant produit par l'élément 16. La réalisation pratique d'une modulation éventuelle s'en trouve donc facilitée. Du fait de la connexion de la seconde boucle à l'entrée $E_{c2}$ de l'oscillateur dont le facteur $K_{vco}$ est le plus élevé, et du gain appliqué par l'amplificateur 14, la tension de commande de l'oscillateur asservi 1 évolue très vite jusqu'au voisinage de la tension optimale permettant le verrouillage, ce qui amène la tension issu de l'intégrateur à l'intérieur de la "fenêtre" du comparateur 15. A l'ouverture du commutateur 12 qui est déclenché alors par le comparateur 15, la tension appliquée à l'entrée $E_{c2}$ se stabilise et la boucle rapide cesse d'agir. L'ajustement de la fréquence obtenue par une variation faible de la tension de commande jusqu'à la valeur optimale assurant le verrouillage, est effectué par la boucle la plus lente. Le bruit de phase propre à la boucle rapide ne s'ajoute que durant le bref intervalle de temps de calage de la fréquence ou de la phase. Pendant tout le temps du calage, seul reste le bruit propre de la boucle lente.

On obtient ainsi une grande vitesse de verrouillage et un bruit de phase permanent faible.

Pour modifier les caractéristiques du dispositif selon l'invention, on peut jouer sur plusieurs paramètres, par exemple :

– le rapport $\dfrac{K_{VCO}}{k_{VCO}}$

– le rapport $\dfrac{d_f}{\Delta VCOL}$

– ou $\Delta VCOL$ est la plage de variation en tension de la boucle la plus lente et $d_f$, on le rappelle, la largeur de la "fenêtre" du comparateur 15, ou bien encore :

– le rapport des constantes d'intégration respectives des intégrateurs 8 et 13.

On veille, par le choix des composants à limiter les courants de fuite du condensateur de mémorisation utilisé dans l'intégrateur 13, pour que la tension mémorisée reste stable durant les intervalles de temps d'ouverture du commutateur 12, de manière à limiter le plus possible toute nouvelle action de la boucle rapide après le calage de l'oscillateur asservi 1.

le dispositif selon l'invention peut être utilisé notamment pour piloter des émetteurs-récepteurs à modulation de fréquence tels que ceux qui assurent les communications entre un laboratoire central de commande et d'enregistrement et différents boîtiers d'acquisition d'un système de transmission de données sismiques par exemple.

Comparativement aux circuits d'asservissement à boucle simple de l'art antérieur, il permet d'élargir la bande passante dans la partie basse du spectre de modulation, de définir avec plus de précision le point de fonctionnement de l'élément qui applique à l'oscillateur asservi la modulation de fréquence et il accroît la vitesse de verrouillage, quelle que soit la largeur de la bande de fréquence où il fonctionne.

Le dispositif selon l'invention peut être utilisé également dans un système de transmission numérique par exemple pour reconstituer un signal ayant même fréquence et même phase qu'un signal numérique transmis sur des lignes et notamment un signal d'horloge.

## Revendications

1. Dispositif à verrouillage de phase, rapide et à faible bruit, pour asservir la fréquence d'un signal (Vs) à celle d'un signal imposé (Vref) issu d'un oscillateur de référence (2), comportant un oscillateur asservi (1) dont la fréquence d'oscillation (fs) est commandée par application d'une tension (Vc1) sur une entrée de commande, une première boucle fermée de contre-réaction comprenant un premier filtre passe-bas (8) pour produire une première tension de commande (Vc1) optimale propre à stabiliser la fréquence de l'oscillateur asservi, le bruit de phase inhérent à ladite première boucle et sa vitesse de réponse étant relativement faibles, caractérisé en ce qu'il comporte en parallèle sur ladite première boucle, une deuxième boucle d'asservissement comportant un deuxième filtre passe-bas (13) dont l'entrée est reliée à la sortie du premier filtre passe-bas (8) et dont la sortie est reliée à une deuxième entrée de commande de l'oscillateur asservi (1), une variation ($\Delta V$) de la tension de commande (Vc2) appliquée à ladite deuxième entrée de commande provoquant un déplacement de la fréquence de sortie de l'oscillateur (1) plus grand que celui produit par la même variation ($\Delta V$) de la tension de commande ($V_{c1}$) appliquée à ladite première entrée, la sortie du premier filtre passe-bas (8) étant reliée à ladite première entrée de commande, et des moyens de contrôle (12/15) pour fermer ladite deuxième boucle par intermittence tant que l'écart entre la tension de commande et ladite valeur optimale, est supérieur à une valeur-seuil déterminée (df), la deuxième boucle incluant un moyen de mémorisation de tension (13).

2. Dispositif selon la revendication 1 ou 4, caractérisé en ce qu'il comporte un moyen (16) d'application d'un signal de modulation dont l'amplitude est choisie inférieure audit écart de tension.

3. Dispositif selon la revendication 1 ou 2, caractérisé en ce que les moyens de contrôle pour fermer la seconde boucle par intermittence comportent des moyens de commutation (12) commandés par un comparateur de tension (15) adapté à comparer la tension de commande avec une valeur de référence (Vfm).

4. Dispositif selon la revendication 1 comportant un modulateur (6) pour mélanger un signal dont la fréquence dépend de celle ($f_s$) du signal issu de l'oscillateur asservi (1) et un autre signal dont la fréquence dépend de celle ($f_R$) du signal issu de l'oscillateur de référence (2) la sortie dudit modulateur étant connectée au premier filtre passe-bas (8), caractérisé en ce que l'oscillateur asservi (1) comporte un circuit oscillant (10) associé à un ensemble de commande, pour faire varier sa fréquence d'oscillation, lequel ensemble comporte un premier moyen capacitif (11, $C_{L1}$) connecté à ladite première entrée de commande, ce premier moyen capacitif étant adapté à provoquer un déplacement de fréquence relativement faible pour une certaine variation de la tension de commande ($\Delta V$) et un deuxième moyen capacitif (12, $C_{L2}$) connecté à ladite deuxième entrée de commande, ce deuxième moyen capacitif étant adapté à provoquer un déplacement de fréquence plus grand que le premier, pour la même variation de la tension de commande.

5. Dispositif selon la revendication 4, caractérisé en ce que la première boucle comporte des moyens de connexion pour relier le premier filtre passe-bas (8) au premier moyen capacitif (11, $C_{L1}$) et le moyen de mémorisation (13) de la seconde boucle sont pourvus d'une entrée connectée aux moyens de filtrage (8) par l'intermédiaire des moyens de commutation (12) et d'une sortie connectée au second moyen capacitif (12, $C_{L2}$).

6. Dispositif selon la revendication 7, caractérisé en ce que le deuxième filtre passe-bas (13) et les moyens de mémorisation (13) comportent un intégrateur à faible constante de temps dont l'entrée est reliée audit moyen de commutation (12).

**Patentansprüche**

1. Vorrichtung mit schneller Phasenverriegelung und schwachem Rauschen, zum Regeln der Frequenz eines Signals ($V_s$) auf die eines von einem Referenzoszillator (2) stammenden vorgeschriebenen Signals ($V_{ref}$), wobei die Vorrichtung einen getriggerten Oszillator (1), dessen Schwingungsfrequenz ($f_s$) durch Anlegen einer Spannung ($V_{c1}$) an einen Steuereingang gesteuert wird, und eine erste gegengekoppelte Schleife umfaßt, die einen ersten Tiefpaßfilter (8) enthält, um eine erste optimale Steuerspannung ($V_{c1}$) zu erzeugen, die zur Stabilisierung der Frequenz des geregelten Oszillators geeignet ist, wobei das der ersten Schleife inhärente Phasenrauschen und seine Antwortgeschwindigkeit relativ niedrig sind, dadurch gekennzeichnet, daß sie parallel zur genannten ersten Schleife eine zweite Regelschleife mit einem zweiten Tiefpaßfilter (13) umfaßt, dessen Eingang mit dem Ausgang des ersten Tiefpaßfilters (8) und dessen Ausgang mit einem zweiten Steuereingang des geregelten Oszillators (1) verbunden ist, wobei eine Störung ($\Delta V$) der an den genannten zweiten Steuereingang angelegten Steuerspannung ($V_{c2}$) eine größere Verschiebung der Frequenz am Ausgang des Oszillators (1) bewirkt als diejenige, die bei gleicher Störung ($\Delta V$) der an den ersten Steuereingang angelegten Steuerspannung ($V_{c1}$) entsteht, und der Ausgang des ersten Tiefpaßfilters (8) mit dem ersten Steuereingang verbunden ist und Steuermittel (12, 15) umfaßt, um die genannte zweite Schleife durch Intermittierung zu schließen, solange die Abweichung zwischen der Steuerspannung und dem genannten optimalen Wert größer als ein festgelegter Schwellwert (df) ist, wobei die zweite Schleife ein Mittel zur Speicherung der Spannung einschließt.

2. Vorrichtung nach einem der Ansprüche 1 oder 4, dadurch gekennzeichnet, daß sie ein Mittel (16) zum Anlegen eines Modulationssignals umfaßt, dessen Amplitude niedriger als die genannte Spannungsabweichung gewählt wird.

3. Vorrichtung nach einem der Ansprüche 1 oder 2, dadurch gekennzeichnet, daß die Steuermittel zum Schließen der zweiten Schleife durch Intermittierung Mittel zur Kommutierung umfassen, die durch einen für den Vergleich der Steuerspannung mit einem Referenzwert($V_{fm}$) ausgelegten Spannungskomparator (15) gesteuert werden.

4. Vorrichtung nach Anspruch 1, wobei die Vorrichtung einen Modulator (6) umfaßt um ein Signal, dessen Frequenz von der ($f_s$) aus dem geregelten Oszillator (1) stammenden Signals abhängt und ein anderes Signal, dessen Frequenz von der ($f_r$) des aus dem Referenzoszillators stammenden Signals abhängt, zu mischen, wobei der Ausgang dieses Modulators mit dem ersten Tiefpaßfilter (8) verbunden ist, dadurch gekennzeichnet, daß der geregelte Oszillator (1) einen mit einer Steuereinheit verbundenen Schwingkreis (10) umfaßt, um seine Schwingungsfrequenz variieren zu können, wobei diese Einheit ein mit dem genannten ersten Steuereingang verbundenes erstes kapazitives Mittel (11, $C_{L1}$), wobei dieses erste kapazitive Mittel ausgelegt ist, um bei einer gewissen Störung der Steuerspannung ($\Delta V$) eine relativ geringe Frequenzverschiebung zu bewirken sowie ein zweites kapazitives Mittel (12, $C_{L2}$) umfaßt, daß mit dem genannten zweiten Steuereingang verbunden ist, wobei dieses zweite kapazitive Mittel ausgelegt ist, um bei der gleichen Störung der Steuerspannung ($\Delta V$) eine größere Frequenzverschiebung als beim Ersten zu bewirken.

5. Vorrichtung nach Anspruch 4, dadurch gekennzeichnet, daß die erste Schleife Verbindungsmittel umfaßt, um den ersten Tiefpaßfilter (8) an das erste kapazitive Mittel (11, $C_{L1}$) anzuschließen und um die Speichermittel (13) der zweiten Schleife, die mit einem Eingang gekoppelt sind, an die Filtermittel (8) über Zwischenschaltung von Kommutierungsmittel (12) und von ein mit dem zweiten kapazitiven Mittel (12, $C_{L2}$) gekoppelten Ausgang anzuschliessen.

6. Vorrichtung nach Anspruch 7, dadurch gekennzeichnet, daß der zweite Tiefpaßfilter (13) und die Speichermittel (13) einen Integrator mit geringer Zeitkonstante umfassen, dessen Eingang an dieses Kommutierungsmittel (12) angeschlossen ist.

**Claims**

1. A device for locking rapidly and with low noise the frequency of a signal (Vs) to that of an imposed signal (Vref) from a reference oscillator (2), comprising a controlled oscillator (1) whose oscillation frequency (fs) may be controlled by applying a voltage (Vc1) to a control input, a first feed-back loop comprising a first low pass filter (8) for producing an optimum initial control voltage (Vc1) to stabilise the frequency of the controlled oscillator, the phase noise inherent to the first loop and its response speed being relatively low, characterised in that it comprises in parallel to the first loop a second servo-loop with a second low passfilter (13) whose input is connected to the output of the first low pass filter (8) and whose output is connected to a second control input of the controlled oscillator (1), wherein a variation ($\Delta V$) in the control voltage (Vc2) applied to the second control input causes a deviation in the output frequency of the oscillator (1) greater than that produced by the same variation ($\Delta V$) of the control voltage (Vc1) applied to the first input, the output of the first low pass filter (8) being connected to the first control input, and control means (12, 15) for closing the second loop intermittently as long as the difference between the control voltage and the optimum value is higher than a given threshold value (df), the second loop including a voltage storage means (13).

2. A device in accordance with claim 1 or 4, characterised in that it comprises a means (16) for applying a modulation signal whose amplitude is chosen at a value less than the voltage difference.

3. A device in accordance with claim 1 or 2, characterised in that the control means for closing the second loop intermittently comprise switching means (12) controlled by a voltage comparator, which is adapted to compare the control tension with a reference value (Vfm).

4. A device in accordance with claim 1, comprising a modulator (6) for mixing a signal whose frequency is dependent on that ($f_s$) of the signal emitted by the control oscillator (1) and another signal whose frequency is dependent on that ($f_R$) of the signal emitted by the reference oscillator (2), the output of the modulator being connected to the first low pass filter (8), characterised in that the controlled oscillator (1) comprises an oscillation circuit (10) associated with a control assembly to permit variation of its oscillation frequency, the assembly having a first capacitive means (11, $C_{L1}$) connected to the first control input, this first capacitive means being adapted to cause a relatively low frequency shift for a certain variation in the control voltage ($\Delta V$) and a second capacitive means (12, $C_{L2}$) connected to the second control input, this second capacitive means being adapted to cause a greater frequency shift than the first for the same variation in control voltage.

5. A device in accordance with claim 4, characterised in that the first loop comprises connection means for linking the first low pass filter (8) to the first capacitive means (11, $C_{L1}$) and the storage means (13) of the second loop are provided with an input connected to the filtering means (8) by switching means (12) and an output connected to the second capacitive means (12, $C_{L2}$).

6. A device in accordance with claim 7, characterised in that the second low pass filter (13) and the storage means (13) comprise an integrator with a low time constant whose input is connected to the switching means (12).

**FIG.2**

**FIG.1**

FIG.3

FIG.4

$V_2$

$\Delta V$

$\Delta F_R$

f

FIG.5

$V_1$

$\Delta V$

$V_c$

$\Delta F_1$

f